# EUROPÄISCHE PATENTSCHRIFT

(11) **EP 0 936 626 B1**
(45) Veröffentlichungstag und Bekanntmachung des Hinweises auf die Patenterteilung: **11.02.2004**
(21) Anmeldenummer: 98124028.6
(22) Anmeldetag: 17.12.1998
(51) Int. Cl.: G11C 16/06

(54) **Elektrisch programmierbarer Nur-Lese-Speicher sowie Verfahren zum Programmieren und Lesen dieses Speichers**
Electrically programmable read-only memory and methods for programming and reading
Mémoire non-volatile programmable électriquement et procédés de programmation et de lecture

(30) Priorität: 12.02.1998 DE 19805782
(43) Veröffentlichungstag der Anmeldung: 18.08.1999
(73) Patentinhaber: Infineon Technologies AG, 81669 München (DE)
(72) Erfinder: Weber, Werner Dr., 80637 München (DE); Wohlrab, Erdmute, 81825 München (DE)
(74) Vertreter: Jannig, Peter, Dipl.-Ing.

(56) Entgegenhaltungen:
- WO-A-94/27295
- US-A- 5 818 761
- GOTOU H: "AN EXPERIMENTAL CONFIRMATION OF AUTOMATIC THRESHOLD VOLTAGE CONVERGENCE IN A FLASH MEMORY USING ALTERNATING WORD-LINE VOLTAGE PULSES" IEEE ELECTRON DEVICE LETTERS, Bd. 18, Nr. 10, 1. Oktober 1997 (1997-10-01), Seiten 503-505, XP000702979 ISSN: 0741-3106

## Beschreibung

Die Erfindung betrifft elektrisch programmierbare Nur-Lese-Speicherzellen, sogenannte Flash EEPROM-Zellen, die durch Fowler Nordheim-Tunneln sowohl gelöscht als auch programmiert werden. Aus Gründen der Selektierbarkeit ist bei diesen EEPROM-Zellen im gelöschten Fall die Einsatzspannung hoch, zum Beispiel 5 V, und im programmierten Fall niedrig, zum Beispiel 1 V. Eine hohe Schwellenspannung bedeutet, daß sich viel negative Ladung auf dem Floating Gate des jeweiligen Zellentransistors befindet. Bei einer niedrigen Schwellenspannung ist das Floating Gate hingegen nicht oder nur wenig geladen. Das Steuergate eines jeweiligen Zellentransistors ist mit einer Wortleitung und der Drainanschluß eines jeweiligen Zellentransistors ist mit einer Bitleitung verbunden. Eine Programmierung erfolgt beispielsweise durch Anlegen von - 10 V an der Wortleitung und 5 V an der Bitleitung. Manchmal lassen sich einzelne Zellen besonders leicht programmieren, was zu einem sogenannten "Überprogrammieren" führen kann, wobei diese Zellen infolge einer positiven Ladung auf dem Floating Gate eine negative Schwellenspannung aufweisen. Beim Auslesen von Zellen liegt die ausgewählte Wortleitung zum Beispiel auf 2,5 V, die entsprechende Bitleitung zum Beispiel auf 1 V und die nicht ausgewählten Wort- und Bitleitungen bleiben auf 0 V. Ist die Schwellenspannung der selektierten Zelle niedrig, dann fließt bei diesen Spannungsbedingungen ein Bitleitungsstrom und die Zelle wird als programmiert erkannt. War die Zelle gelöscht, so fließt normalerweise kein Bitleitungsstrom, ist jedoch die Schwellenspannung durch Überprogrammieren negativ, dann fließt durch diese Zellen trotzdem ein Strom, obwohl sie gar nicht ausgewählt wurden. Wird jetzt zum Beispiel eine eigentlich gelöschte Zelle ausgelesen, kann es zu einer falschen Bewertung kommen. Aus diesem Grund müssen negative Werte der Schwellenspannung generell vermieden werden. Für kleinere Betriebsspannungen oder Multi-Level-Anwendungen soll außerdem die Verteilung der Einsatzspannungen eines Zellenfeldes möglichst gering und der Wert der Schwellenspannung einstellbar sein.

Aus den IEEE Electronic Device Letters, Vol. 16, No. 3, March 1995, Seiten 121 bis 123, ist eine Vorrichtung bekannt, bei der die Bitleitung entweder über einen Ladetransistor mit 5 V aufladbar oder über einen Entladetransistor auf 0 V entladbar ist. Das Problem der sogenannten Überprogrammierung wird hierbei durch eine sogenannte selbstkonvergierende Programmierung verhindert. Letzteres geschieht dadurch, daß während einer negativen Phase eines Pulses an der Wortleitung die negative Ladung auf dem Floating Gate und damit die Einsatzspannung der Zelle sinkt und in einer positiven Phase des Pulses der Wortleitung geprüft wird, ob die gewünschte Schwellenspannung bereits erreicht ist oder nicht. Falls die gewünschte Schwellenspannung erreicht ist, öffnet die Zelle und entlädt dadurch die Bitleitung, wodurch folgende negative Pulse keine weitere Programmierung mehr bewirken. Messungen haben jedoch gezeigt, daß die Bitleitung durch Leckströme zum Substrat hin frühzeitig entladen wird und dadurch oftmals nur eine unvollständige Programmierung erfolgt.

Aus dem IEEE-Paper zur IEDM 96, 7.4.1 bis 7.4.4, Seiten 181 bis 184, ist bekannt, daß die Bitleitung durch einen schwach geöffneten Transistor nachgeladen werden und dadurch ein zu geringes Programmieren vermieden werden kann. Nachteilig ist hier jedoch, daß dies nur bei einer ganz bestimmten Bitleitungsspannung am Nachladetransistor funktioniert und schon geringe Abweichungen, von beispielsweise 0,1 V, entweder ein zu geringes Programmieren oder ein Nichtkonvergieren auf den gewünschten Schwellenspannungswert erfolgt. Ein weiterer Nachteil besteht darin, daß die Programmierphase nicht länger als ungefähr 1 µs sein darf, da sonst während des Programmierens die Bitleitung über den Nachladetransistor wieder aufgeladen und die Zelle somit weiterprogrammiert wird. Durch eine zu geringe Programmierpulsbreite sind viele Programmier/Lese-Zyklen erforderlich, was die gesamte Programmierzeit unnötig verlängert.

Die der Erfindung zugrundeliegende Aufgabe besteht nun darin, einen Nur-Lese-Speicher mit einer Vorrichtung zur Bewertung und Regelung der Bitleitungsspannung und Verfahren zu deren Programmierung und zum Lesen dieses Speichers anzugeben, bei dem/denen obengenannte Nachteile vermieden werden und die gewünschte Schwellenspannung der Speicherzelle in weiten Grenzen frei wählbar und relativ genau einstellbar ist.

Diese Aufgabe wird hinsichtlich des Speichers durch Anspruch 1 und hinsichtlich der Verfahrens durch die Ansprüche 2 und 4 gelöst. Weitere Ausgestaltungen der Erfindung ergeben sich aus den Unteransprüchen 3 und 5.

Weitere Vorteile der Erfindung liegen unter anderem darin, daß die Vorrichtung weitgehend unabhängig von Versorgungsspannungsschwankungen arbeitet, daß nur die bisher üblichen Programmier/Lesespannungspegel benötigt werden und daß relativ hohe Leckströme der Bitleitung toleriert werden.

Ein bevorzugtes Ausführungsbeispiel der Erfindung wird nachfolgend anhand der Zeichnung näher erläutert. Dabei zeigt
- Figur 1: ein Blockschaltbild des erfindungsgemäßen Ausführungsbeispiels und
- Figur 2: zugehörige Impulsdiagramme zur Erläuterung der Funktionsweise der in Figur 1 dargestellten Vorrichtung.

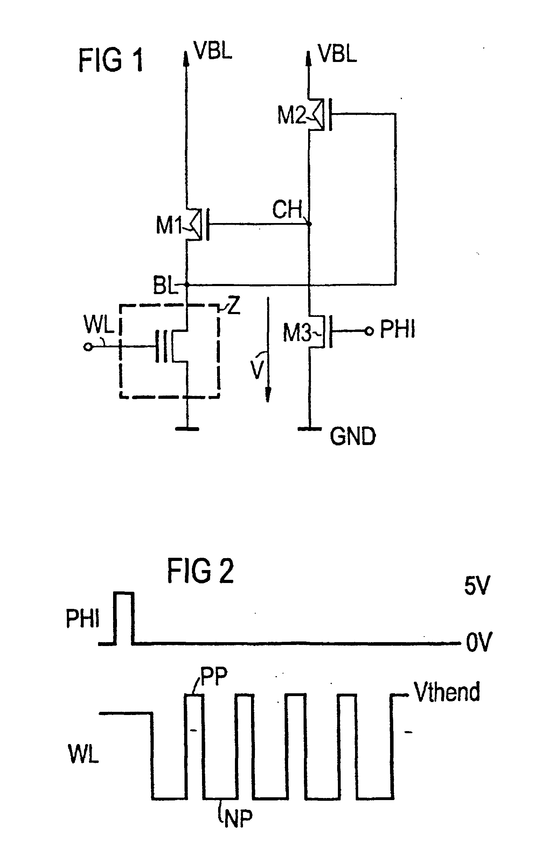

In Figur 1 ist stellvertretend für mehrere Flash EEPROM-Speicherzellen eine Zelle Z dargestellt, die aus einem Transistor mit Floating Gate besteht, dessen Steuergate mit der Wortleitung WL, dessen Drainanschluß mit der Bitleitung BL und dessen Sourceanschluß mit Bezugspotential GND verbunden ist. Die eigentliche Vorrichtung zur Bewertung und Regelung der Bitleitungsspannung auf der Bitleitung BL weist zwei p-Kanal-MOS-Transistoren M1 und M2 sowie einen n-Kanal-MOS-Transistor M3 auf, wobei die Bitleitung BL über den Transistor M1 mit einer Bitleitungsversorgungsspannung VBL verbindbar ist. Das Gate des Transistors M2 ist mit der Bitleitung BL verbunden und das Gate des Transistors M3 ist mit einer pulsförmigen Spannung PHI beaufschlagt. Die beiden Transistoren M2 und M3 sind dabei in Reihe geschaltet, wobei ein erster Anschluß des Transistors M2 mit der Bitleitungsversorgungsspannung VBL und ein erster Anschluß des Transistors M3 mit Bezugspotential GND und ein Verbindungsknoten CH der beiden Transistoren mit dem Gate des Transistors M1 verbunden sind.

Wie in Figur 2 gezeigt, wird zu Beginn der Programmierung durch den positiven Puls PHI am Gate des Transistors M3 bewirkt, daß der Transistor M3 öffnet und somit der Knoten CH bzw. das Gate des Transistors M1 Massepotential erhält, wodurch wiederum der Transistor M1 geöffnet wird und damit die Bitleitungsversorgungsspannung VBL als Spannung V an der Bitleitung BL anliegt. Jetzt kann wie bei den eingangs zitierten bekannten Vorrichtungen eine Programmierung durch Anlegen von negativen Pulsen an der Wortleitung programmiert werden. In der positiven Phase des Pulses wird, wie beim Stand der Technik bereits beschrieben, bewertet, ob die Zelle schon genügend programmiert wurde. Wurde die gewünschte Schwellenspannung Vthend erreicht, so wird die Zelle leitend und die Spannung an der Bitleitung BL wird geringer, dadurch öffnet sich der Transistor M2, was ein Schließen des Transistors M1 bewirkt. Dies führt zur Entkopplung von der Bitleitungsversorgungsspannung VBL und zur Entladung der Bitleitung BL über die nun leitende Zelle auf Bezugspotential. Damit ist die Programmierung für die Zelle Z abgeschlossen. Wie beim eingangs zitierten Stand der Technik ist die Vorrichtung pro Bitleitung eines Zellenfeldes einmal auszuführen, damit alle mit einer Wortleitung verbundenen Zellen gleichzeitig programmiert werden können.

Auch mehrwertige Speicher können auf sichere und einfache Weise programmiert werden, wobei durch Veränderung der Amplitude der Programmierimpulse verschiedene Schwellenspannungen und damit mehr als zwei Logikzustände programmierbar sind.

Die Vorrichtung kann auch als Leseverstärker betrieben werden, wobei an die Wortleitung WL kein Programmierimpuls, sondern eine Lesespannung, deren Wert höher als die gewünschte Schwellenspannung Vthend gewählt wird, angelegt wird. Der n-Kanal-MOS-Transistor (M3) wird dabei so beschaltet, daß er die Bitleitung über den p-Kanal-MOS-Transistor (M1) auf eine Bitleitungslesespannung VBL' vorläd, die in der Regel niedriger als die Bitleitungsversorgungsspannung VBL ist. Beim Auslesen gibt eine logische Null oder eine logische Eins auf der Bitleitung BL Auskunft darüber, ob die Zelle gelöscht oder programmiert ist.

Entsprechend ist auch ein Leseverstärker für mehrwertige Speicher denkbar, wenn die Zelle mit verschiedenen Spannungen an der Wortleitung ausgelesen wird.

## Patentansprüche

1. Elektrisch programmierbarer Nur-Lese-Speicher mit mindestens einer Vorrichtung (M1, M2, M3) zur Bewertung und Regelung mindestens der Spannung (V) einer Bitleitung (BL),
- bei dem mindestens eine Speicherzelle (Z) vorhanden ist, die einen Transistor mit Floating Gate aufweist, dessen Steuergate mit der Wortleitung (WL), dessen Drainanschluß mit der Bitleitung (BL) und dessen Sourceanschluß mit Bezugspotential (GND) verbunden ist,
- bei dem die Bitleitung über einen ersten p-Kanal-MOS-Transistor (M1) mit einer Bitleitungsversorgungsspannung (VBL) verbindbar ist, dessen Gate (CH) über einen zweiten p-Kanal-MOS-Transistor (M2) mit einer Bitleitungsversorgungsspannung (VBL) und über einen n-Kanal-MOS-Transistor (M3) mit Bezugspotential (GND) verbindbar ist, und
- bei dem die Bitleitung mit dem Gate des zweiten p-Kanal-MOS-Transistor verbunden und das Gate des n-Kanal-MOS-Transistor (M3) mit einem Eingang für eine pulsförmige Spannung (PHI) verbunden ist.

2. Verfahren zum Programmieren des Nur-Lese-Speichers nach Anspruch 1,
bei dem durch die pulsförmige Spannung (PHI) mit Hilfe des n-Kanal-MOS-Transistors (M3) und des ersten p-Kanal-MOS-Transistors (M1) bewirkt wird, daß die Bitleitung (BL) mit der Bitleitungsversorgungsspannung (VBL) verbunden wird,
bei dem anschließend an der Wortleitung (WL) eine Pulsfolge mit negativen (NP) und positiven Pulsen (PP) angelegt wird, wobei während der negativen Pulse die mindestens eine Speicherzelle programmiert und während der positiven Pulse geprüft wird, ob eine gewünschte Schwellenspannung (Vthend) des Transistors der mindestens einen Speicherzelle bereits erreicht ist, und
bei dem nach Erreichen der gewünschten Schwellenspannung (Vthend) die mindestens eine Speicherzelle leitend und die Spannung an der Bitleitung infolgedessen geringer wird sowie ein Öffnen des zweiten p-Kanal-MOS-Transistor (M2) und ein Schließen des p-Kanal-MOS-Transistor (M1) bewirkt, wobei die Bitleitung von der Bitleitungsversorgungsspannung (VBL) entkoppelt und über die nun leitende mindestens eine Speicherzelle auf Bezugspotential entladen wird.

3. Verfahren zum Programmieren des Nur-Lese-Speichers nach Anspruch 2,
bei dem unterschiedliche gewünschte Schwellenspannungen (Vthend) erzeugt werden, wobei eine jeweilige gewünschte Schwellenspannung durch eine entsprechende Amplitude der positiven Pulse (PP) eingestellt wird.

4. Verfahren zum Lesen des Nur-Lese-Speichers nach Anspruch 1,
bei dem der n-Kanal-MOS-Transistor (M3) so beschaltet wird, daß er die Bitleitung über den p-Kanal-MOS-Transistor (M1) auf die Bitleitungslesespannung (VBL') vorläd,
bei dem anschließend an der Wortleitung (WL) einer jeweiligen Speicherzelle (Z) eine Lesespannung angelegt wird, die positiver als eine programmierte Schwellenspannung (Vthend) des Transistors dieser Speicherzelle ist, und
bei dem anschließend die Spannung (V) der Bitleitung (BL) den logischen Zustand dieser Speicherzelle wiedergibt.

5. Verfahren zum Lesen des Nur-Lese-Speichers nach Anspruch 4,
bei dem Speicherzellen mit unterschiedlichen Lesespannungen an den Wortleitungen (WL) der zu lesenden Speicherzellen ausgelesen werden.

## Claims

1. Electrically programmable read-only memory having at least one device (M1, M2, M3) for evaluating and regulating at least the voltage (V) of a bit line (BL),
- in which at least one memory cell (Z) is present, which has a transistor with a floating gate, whose control gate is connected to the word line (WL), whose drain terminal is connected to the bit line (BL) and whose source terminal is connected to reference-earth potential (GND),
- in which the bit line can be connected to a bit line supply voltage (VBL) via a first p-channel MOS transistor (M1), whose gate (CH) can be connected to a bit line supply voltage (VBL) via a second p-channel MOS transistor (M2) and to reference-earth potential (GND) via an n-channel MOS transistor (M3), and
- in which the bit line is connected to the gate of the second p-channel MOS transistor and the gate of the n-channel MOS transistor (M3) is connected to an input for a pulsed voltage (PHI).

2. Method for programming the read-only memory according to Claim 1,
in which the pulsed voltage (PHI) with the aid of the n-channel MOS transistor (M3) and the first p-channel MOS transistor (M1) has the effect of connecting the bit line (BL) to the bit line supply voltage (VBL),
in which a pulsed drain with negative (NP) and positive pulses (PP) is subsequently applied to the word line (WL), the at least one memory cell being programmed during the negative pulses and a check being made during the positive pulses to determine whether a desired threshold voltage (Vthend) of the transistor of the at least one memory cell has already been reached, and
in which after the desired threshold voltage (Vthend) has been reached, the at least one memory cell becomes conducting and the voltage from the bit line consequently becomes lower and the second p-channel MOS transistor (M2) is opened and the p-channel MOS transistor (M1) is closed, the bit line being decoupled from the bit line supply voltage (VBL) and being discharged to reference-earth potential via the at least one memory cell that is now conducting.

3. Method for programming the read-only memory according to Claim 2,
in which different desired threshold voltages (Vthend) are generated, a respective desired threshold voltage being set by means of a corresponding amplitude of the positive pulses (PP).

4. Method for reading the read-only memory according to Claim 1,
in which the n-channel MOS transistor (M3) is connected up in such a way that it precharges the bit line to the bit line read voltage (VBL') via the p-channel MOS transistor (M1),
in which a read voltage is subsequently applied to the word line (WL) of a respective memory cell (Z), the said read voltage being more positive than a programmed threshold voltage (Vthend) of the transistor of this memory cell, and
in which the voltage (V) of the bit line (BL) subsequently reduces the logic state of this memory cell.

5. Method for reading the read-only memory according to Claim 4,
in which memory cells are read with different read voltages on the word lines (WL) of the memory cells to be read.

## Revendications

1. Mémoire en lecture seule programmable électriquement avec au moins un dispositif (M1, M2, M3) pour l'évaluation et la régulation au moins de la tension (V) d'une ligne de bit (BL),
- comportant au moins une cellule mémoire (Z) présentant un transistor à grille flottante dont la grille de commande est reliée à la ligne de mot (WL), dont la connexion de drain est reliée à la ligne de bit (BL) et dont la connexion de source est reliée au potentiel de référence (GND),
- dont la ligne de bit peut être reliée à une tension d'alimentation de la ligne de bit (VBL) par l'intermédiaire d'un premier transistor MOS à canal p (M1), dont la grille (CH) peut être reliée à une tension d'alimentation de la ligne de bit (VBL) par l'intermédiaire d'un second transistor MOS à canal p (M2) et au potentiel de référence (GND) par l'intermédiaire d'un transistor MOS à canal n (M3), et
- dont la ligne de bit est reliée à la grille du second transistor MOS à canal p et la grille du transistor MOS à canal n (M3) est reliée à une entrée pour une tension pulsée (PHI).

2. Procédé pour programmer la mémoire en lecture seule selon la revendication 1,
dans lequel la tension pulsée (PHI), à l'aide du transistor MOS à canal n (M3) et du premier transistor MOS à canal p (M1), provoque la connexion de la ligne de bit (BL) avec la tension d'alimentation de la ligne de bit (VBL),
dans lequel une suite d'impulsions, avec des impulsions négatives (NP) et positives (PP), est ensuite appliquée sur la ligne de mot (WL), l'au moins une cellule mémoire étant programmée pendant les impulsions négatives, et il est vérifié, pendant les impulsions positives, si une tension de seuil (Vthend) souhaitée du transistor de l'au moins une cellule mémoire est déjà atteinte, et
lorsque la tension de seuil (Vthend) souhaitée est atteinte, l'au moins une cellule mémoire devient conductrice et à la suite de quoi la tension sur la ligne de bit diminue et provoque une ouverture du second transistor MOS à canal p (M2) et une fermeture du transistor MOS à canal p (M1), la ligne de bit étant découplée de la tension d'alimentation de la ligne de bit (VBL) et déchargée, par l'intermédiaire de l'au moins une cellule mémoire devenue conductrice, au potentiel de référence.

3. Procédé pour programmer la mémoire en lecture seule selon la revendication 2,
dans lequel des tensions de seuil souhaitées (Vthend) différentes sont générées, chaque tension de seuil souhaitée étant réglée par une amplitude correspondante des impulsions positives (PP).

4. Procédé pour lire la mémoire en lecture seule selon la revendication 1,
dans lequel le transistor MOS à canal n (M3) est alimenté de sorte qu'il précharge la ligne de bit à la tension de lecture de ligne de bit (VBL') par l'intermédiaire du transistor MOS à canal p (M1),
dans lequel une tension de lecture, plus positive qu'une tension de seuil (Vthend) programmée du transistor de cette cellule mémoire, est ensuite appliquée sur la ligne de mot (WL) de la cellule mémoire (Z) concernée, et
dans lequel la tension (V) de la ligne de bit (BL) indique ensuite l'état logique de cette cellule mémoire.

5. Procédé pour lire la mémoire en lecture seule selon la revendication 4,
dans lequel des cellules mémoire sont lues avec des tensions de lecture différentes sur les lignes de mot (WL) des cellules mémoire à lire.
